# EUROPEAN PATENT APPLICATION

(11) **EP 2 953 154 A1**
(43) Date of publication of application: **09.12.2015**
(21) Application number: 14305829.5
(22) Date of filing: 02.06.2014
(51) Int. Cl.: H01L 21/02

(54) **Usage of Si-O-Si based molecules for high efficiency Si solar cells**

(71) Applicant: L'AIR LIQUIDE, SOCIETE ANONYME POUR L'ETUDE ET L'EXPLOITATION DES PROCEDES GEORGES CLAUDE, 75007 Paris (FR); CENTRE NATIONAL DE LA RECHERCHE SCIENTIFIQUE, 75794 Paris Cedex 16 (FR); L'ECOLE POLYTECHNIQUE, 91120 Palaiseau (FR)
(72) Inventor: Goyal, Prabal, 91120 Palaiseau (FR); Lahootun, Vanina, 91270 Vigneux sur Seine (FR); Johnson, Erik, 75020 Paris (FR)
(74) Representative: Grout de Beaufort, François-Xavier

(57) **Abstract**

Method for deposing on a substrate a microcrystalline silicon oxide layer of formula SiOₓ:H, where 0 < x < 2, comprising introducing into a deposition zone where the substrate is located a gas mixture comprising :
- a silicon precursor of (R¹R²R³)Si-O-Si(R⁴R⁵R⁶) where R¹-R⁶ are organic ligands independently selected from the group consisting of H, C1-C5 linear or branched, alkyl, aryl, alkenyl ; and
- monosilane, hydrogen and a doping source.

## Description

The invention concerns the use of Si-O-Si based molecules for the deposition of undoped and doped microcrystalline silicon oxide (µc-SiOx:H) films on a substrate surface (silicon wafers, glass, metals). The doped µc-SiOx:H can be used as a p type layer or a n type layer in single junction and multi-junction silicon thin film solar cells or as the Silicon Oxide Intermediate Reflector (SOIR) in multi-junction silicon thin film solar cells.

Undoped and doped hydrogenated microcrystalline silicon oxide (µc-SiOx:H) thin films have attracted particular scientific interest due to their potential applications in single and multi-junction thin film solar cells. The most widely used method for producing the material is Plasma Enhanced Chemical Vapor Deposition (PECVD) method from highly diluted SiH₄ in H₂ discharges with water, oxygen, N₂O or most often carbon dioxide gas as an oxygen source. The doping is done using B₂H₆, Trimethylborane (TMB) as 'p' type dopant and PH₃ as 'n' type dopant.

These p and n type doped layers can be used as p and n type layers in single junction and multi-junction amorphous layers. The doped µc-SiOx:H can also be used as Silicon Oxide Intermediate Reflector (SOIR) in multi-junction solar cells.

µc-SiOx:H films consist of a mixed phase material based on an oxygen rich amorphous silicon oxide and a doped microcrystalline silicon phase. Depending on the nature of the oxidant gas and their ratios, the properties of the films varies. With an increase in the oxidant content, more oxygen is incorporated in the films and the material gets a reduced refractive index (compared to Si) but the electrical conductivity decreases and the structure of the material changes from highly crystalline to fully amorphous.

The domain of the properties (refractive index, optical band gap, conductivity, mechanical and material) which can be explored when using water, oxygen, N₂O or CO₂ as the O source in µc-SiOx:H is limited.

The presence of doped layers is necessary for the fabrication of thin-film silicon solar cells, but these layers also give parasitic absorption, decreasing cell efficiency. Consequently there is a need for depositing microcrystalline silicon oxide (µc-SiOx:H) film on a substrate surface with superior qualities, notably conductivity and transparency with better control of film properties during the deposition processes and thus resulting in thin film Si solar cells with improved efficiencies.

Consequently, an object of the present invention is a method for deposing on a substrate a microcrystalline silicon oxide layer of formula SiOₓ:H, where 0 < x < 2, comprising introducing into a deposition zone where the substrate is located a gas mixture comprising :
- a silicon precursor of (R¹R²R³)Si-O-Si(R⁴R⁵R⁶) where R¹-R⁶ are organic ligands independently selected from the group consisting of H, C1-C5 linear or branched, alkyl, aryl, alkenyl ; and
- monosilane, hydrogen and a doping source.

According to other embodiments, the invention concerns:

A method as defined above, wherein the silicon oxide layer is a p-type layer and the doping source comprises at least one atom of Bore.

A method as defined above, wherein the silicon oxide layer is a p-type layer and the doping source is diborane.

A method as defined above, wherein the silicon oxide layer is a n-type layer and the doping source comprises at least one atom of Phosphorus.

A method as defined above, wherein the silicon oxide layer is a n-type layer and the doping source is phosphine.

A method as defined above, wherein the silicon precursor is hexamethyldisiloxane (HMDSO) or tetramethyldisiloxane (TMDSO).

A method as defined above, wherein the deposition is performed by chemical vapour deposition and comprises at least one cycle comprising the following steps:
(i) introducing the silicon precursor into a deposition zone where the substrate is located; and
(ii) introducing the gas mixture of monosilane, hydrogen and a doping source into the deposition zone.

A method as defined above, wherein the steps are performed simultaneously.

A method as defined above, wherein the steps are performed sequentially.

A method as defined above, wherein the temperature maintained in the deposition zone is comprised between 150°C and 250°C and the pressure maintained in the deposition zone is comprised between 133 Pa and 333 Pa.

A method as defined above, wherein the gas mixture introduced at step (ii) comprised, for 100% in volume, between 0.2% and 1% of monosilane.

A method as defined above, wherein the silicon precursor is added to the gas mixture in a range comprised, in volume, between 10% and 100% of the monosilane.

In Si-O-Si based molecules according to the invention, there is one Oxygen atom and two Silicon atoms. This results in a better control of the properties of the deposited films and serves as an extra source of Silicon which leads to the formation of denser Silicon thin films. These enhanced properties enable to achieve high efficiency thin film solar cells and one needs to explore this subject further and invoke the use of advanced Si-O-Si based molecules during the deposition of µc-SiOx:H films.

Si-O-Si based molecules have been used for depositing microcrystalline silicon oxide (µc-SiOx:H) film on a substrate surface with superior qualities, notably conductivity and transparency. Molecules like HMDSO and TMDSO are being used for the depositions. These molecules give better control of film properties during the deposition processes and thus result in thin film Si solar cells with improved efficiencies.

These molecules are used for the deposition of high quality undoped and doped microcrystalline silicon oxide (µc-SiOx:H) film on a substrate surface.

These Si-O-Si molecules present advantages over the conventional water, oxygen, N₂O or CO₂ as source of oxygen atom in the deposition of intrinsic and doped microcrystalline silicon oxide (µc-SiOx:H) film on a substrate surface in the following ways:
1. Si-O-Si based molecules according to the invention have only one Oxygen atom and two Silicon atoms. During the deposition in a CVD system, the oxidation of microcrystalline Silicon will be limited and two additional Silicon atoms will result in the deposition of denser intrinsic and doped microcrystalline silicon oxide (µc-SiOx:H) film.
2. These Si-O-Si based molecules according to the invention, have sufficient volatility for vapour phase distribution and can be distributed easily using a conventional liquid molecule distribution system.

Those skilled in the art will recognise that these molecules can also be used for various other applications like deposition of SiOC films which have a higher band gap and can be used in the doped layers of a thin film Si Solar cell.

A preferred method for deposition of hydrogenated microcrystalline silicon oxide thin films is as following:
1. A mixture of 0.2% to 1 % silane is used in hydrogen.
2. The flow rate of SiH₄ ranges from 0 to 10 sccm.
3. The power densities can be ranged from 0 to 800 mW/cm².
4. Si-O-Si based molecule (HMDSO, TMDSO,...) is added to the mixture and it ranges from 10% to 100% of the SiH₄.
5. The applied pressure was between 133 Pa to 333 Pa.
6. The temperature of the substrate ranges from 150°C to 250°C.

### EXAMPLES

### Example 1 - Hydrogenated micro-crystalline silicon oxide films

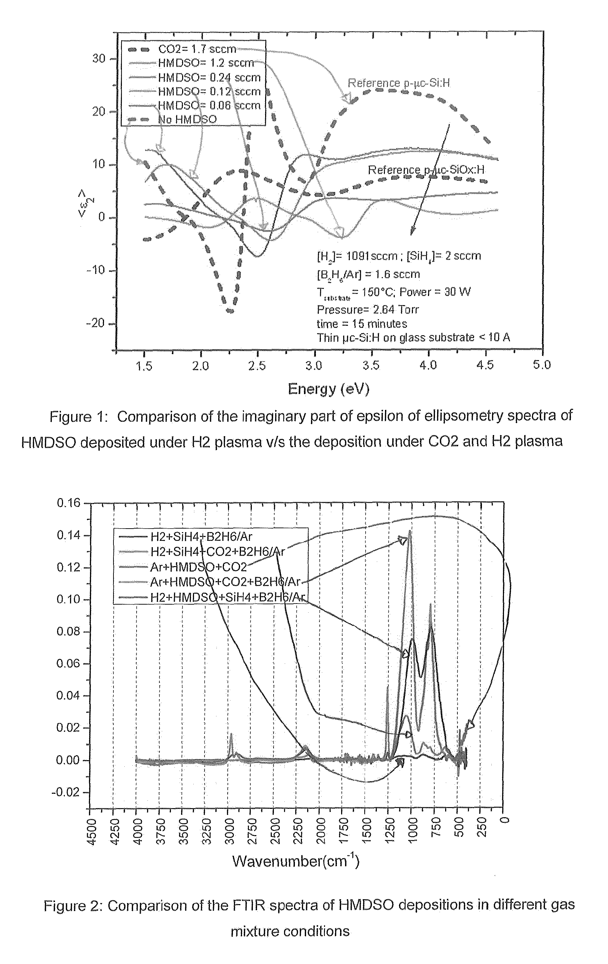

µc-SiOx:H is obtained by implementing a gas mixture comprising of monosilane, hydrogenand Si-O-Si based molecules according to the invention under CVD conditions. Figure 1 compares the ellipsometry spectra obtained through the depositions with HMDSO with the undoped and 'p' type doped µc-SiOx:H films. As seen in Figure 1, the intensity of ellipsometry spectra from the 'p' type µc-SiOx:H films obtained from HMDSO as the oxygen source decreases as HMDSO flow rate increases. This indicates that the Oxygen content in the films is increasing.

Figure 2 compares the FTIR spectra of the depositions in different gas mixture conditions. The FTIR spectra of the p type µc-Si:H films, p type µc-SiOx:H films from CO₂ and p type µc-SiOx:H films from HMDSO is shown. The presence of a peak (∼1200 cm⁻¹) in FTIR spectra indicates the presence of Si-O. This peak is seen in the FTIR spectra of SiO₂ films, p-µc-SiOx:H from CO₂ as Oxygen source and p-µc-SiOx:H from HMDSO as the Oxygen source.

The described Si-O-Si molecules of the invention presents a new method to deposit undoped and doped microcrystalline silicon oxide (µc-SiOx:H) film on a substrate surface. These films have superior properties (refractive index, optical band gap, conductivity, mechanical and material) than the conventional films deposited from other oxygen sources like water, oxygen, N₂O and CO₂. These enhanced properties will facilitate the increased efficiencies of the solar cells.

### Example 2 - p-type microcrystalline silicon oxide layers using HMDSO as the Oxygen source.

The doped layers (p-type and n-type) in thin film silicon solar cells are necessary to provide an electron-hole separation mechanism. These layers are a source of parasitic absorption, but can provide an advantage if they provide greater control over optical reflection.

Doped microcrystalline silicon oxide (µc-SiOx:H) is a material which has gained scientific interest because of its reduced optical absorption while still generating sufficient electric field for electron-hole separation.

In this example, the use of Hexamethyldisiloxane (C₆H₁₈OSi₂, HMDSO) as an oxygen source for microcrystalline silicon oxide p-type layers deposited by PECVD is illustrated. The use of molecules with pre-formed Si-O-Si bonds as the oxygen source growth precursor is expected to provide different material properties ascompared to when the Oxygen arrives as either an atom or as a hydroxyl group (-OH). Conventionally, CO₂ is used as the Oxygen source for depositing p-type µc-SiOx:H layers.

p-µc-SiOx:H layers were deposited on glass substrate (AF-32) and FZ Wafer. The refractive index (n) of the layers was estimated by fitting the Ellipsometry curves on Delta-Psi2 software. The coplanar conductivities were evaluated by evaporating metal contacts on the deposited layers and measuring the current at a specified voltage. The bond configuration in the films was confirmed with Fourier Transform Infrared Spectroscopy (FTIR). The elemental composition and density of the elements in the deposited films was checked with Secondary Ion Mass Spectroscopy (SIMS) analysis. All the properties of the films were compared with the p-µc-SiOx:H layers using CO₂ as Oxygen source.

The p-type layers from HMDSO were also tested in a single junction amorphous silicon p-i-n type device structures which demonstrated the functioning of the new p-type layers in the devices.

### Refractive Index.

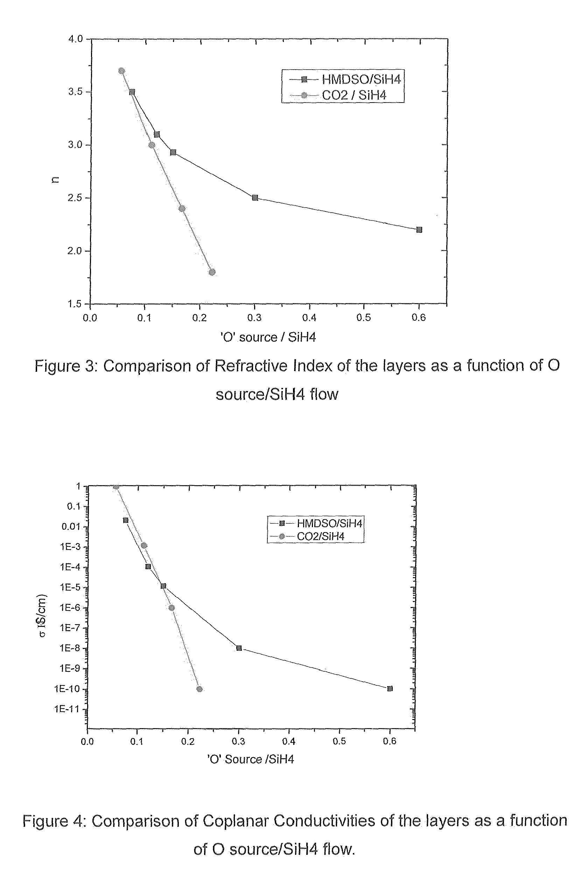

Figure 3 shows the comparison of Refractive Index (n) of the layers as a function of Oxygen source/SiH₄ flow. The Oxygen source is HMDSO in one case and CO₂ in another case.

As seen in Figure 3, with HMDSO, layers were obtained in the range of n ∼3.5 to 2.2 while with CO₂, n changed drastically (2.3 to 1.7) with a slight increase in CO₂ flow.

### Coplanar conductivity.

Figure 4 shows the comparison of coplanar conductivities of the layers as a function of Oxygen source/SiH₄ flow.

As seen in Figure 4, it was easier to control the conductivities between 10⁻⁴ S/cm and 10⁻¹⁰ S/cm with HMDSO compared to CO₂. These layers are interesting for p-type layer in a single junction cell and as an Intermediate Reflector Layer (IRL) in a micromorph cell.

### Fourier Transform Infrared Spectroscopy (FTIR).

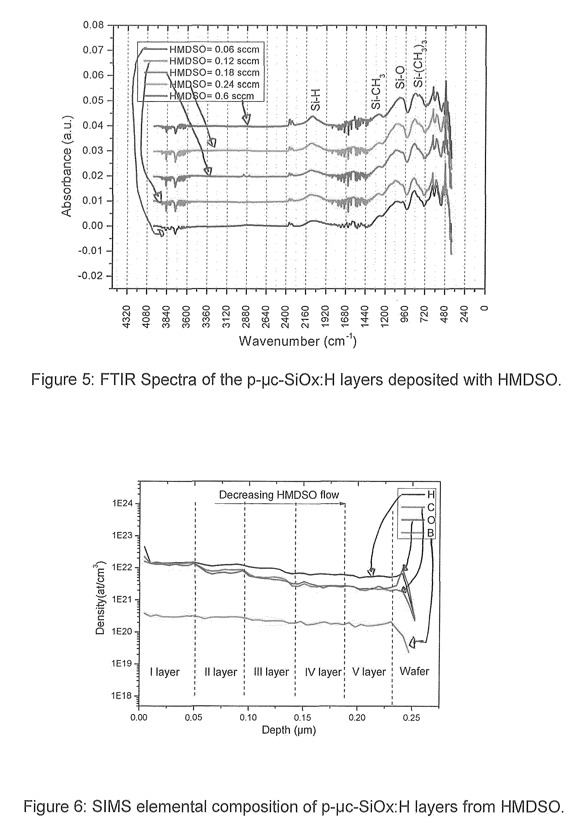

Figure 5 shows the FTIR Spectra of the p-µc-SiOx:H layers deposited with HMDSO.

As seen in Figure 5, there is a peak at 1100 cm⁻¹ which indicates Si-O bond in the deposited films. This peak is typically seen in the FTIR spectra of the µc-SiOx:H layers.

### Secondary Ion Mass Spectroscopy (SIMS) analysis.

The p-type layers from HMDSO were deposited on FZ Crystalline Wafer substrate and SIMS analysis were performed to know the elemental composition and the density. Figure 6 shows the elements and their densities in p-µc-SiOx:H layers from HMDSO.

As seen in Figure 6, the C density is ∼10²² at/cm³ while in the standard p-µc-SiOx:H layers, it is about ∼10²¹at/cm³. This is expected because HMDSO has six CH₃ groups. The other elements (B, Si, H, O) have almost similar densities.

### Test of p-type layers in single junction p-i-n structure.

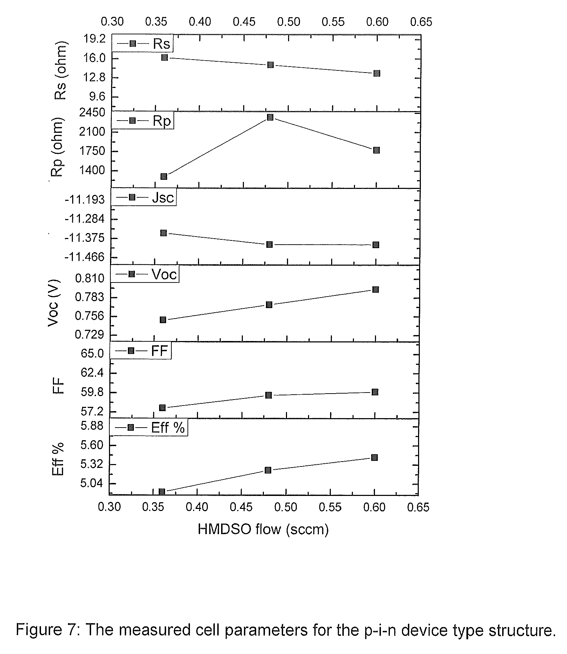

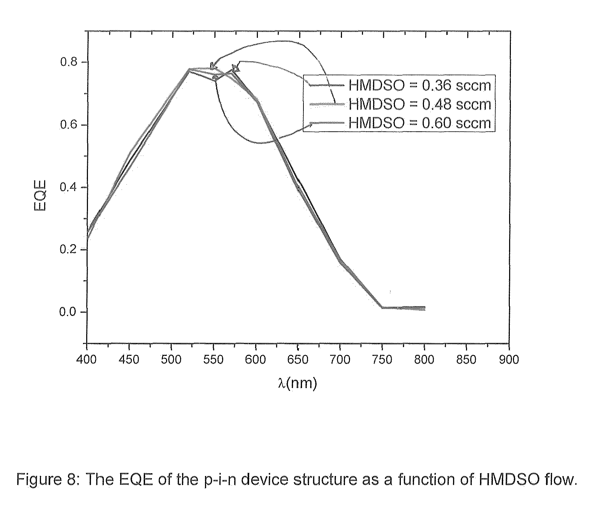

The p-type layers from HMDSO were also tested in a single junction silicon p-i-n type device structures. Figure 7 shows the cell parameters as a function of HMDSO flow while Figure 8 shows the External Quantum Efficiency (EQE).

The p-type layers were tested in a single junction silicon p-i-n type device structures, and the following best cell parameters (Jsc= 11.4 mA/cm², Voc= 0.81 V, FF= 60, η = 5.5 %) were obtained using very thick p-layers and aluminium back reflectors. Further, annealing of the cells led to a small increase in Voc, but the main limitation (low current) is expected to be overcome using thinner p-layers and an improved back reflector.

## Claims

1. A method for deposing on a substrate a microcrystalline silicon oxide layer of formula SiOₓ:H, where 0 < x < 2, comprising introducing into a deposition zone where the substrate is located a gas mixture comprising :
- a silicon precursor of (R¹R²R³)Si-O-Si(R⁴R⁵R⁶) where R¹-R⁶ are organic ligands independently selected from the group consisting of H, C1-C5 linear or branched, alkyl, aryl, alkenyl ; and
- monosilane, hydrogen and a doping source.

2. A method according to Claim 1, wherein the silicon oxide layer is a p-type layer and the doping source comprises at least one atom of Bore.

3. A method according to Claim 2, wherein the silicon oxide layer is a p-type layer and the doping source is diborane.

4. A method according to Claim 1, wherein the silicon oxide layer is a n-type layer and the doping source comprises at least one atom of Phosphorus.

5. A method according to Claim 4, wherein the silicon oxide layer is a n-type layer and the doping source is phosphine.

6. A method according to anyone of claims 1 to 5 wherein the silicon precursor is hexamethyldisiloxane (HMDSO) or tetramethyldisiloxane (TMDSO).

7. A method according to anyone of claims 1 to 6 wherein the deposition is performed by chemical vapour deposition and comprises at least one cycle comprising the following steps:
(i) introducing the silicon precursor into a deposition zone where the substrate is located; and
(ii) introducing the gas mixture of monosilane, hydrogen and a doping source into the deposition zone.

8. A method according to Claim 7, wherein the steps are performed simultaneously.

9. A method according to Claim 7, wherein the steps are performed sequentially.

10. A method according to anyone of preceding claims, wherein the temperature maintained in the deposition zone is comprised between 150°C and 250°C and the pressure maintained in the deposition zone is comprised between 133 Pa and 333 Pa.

11. A method according to anyone of claims 7 to 10, wherein the gas mixture introduced at step (ii) comprised, for 100% in volume, between 0.2% and 1% of monosilane.

12. A method according to anyone of claims 7 to 11, wherein the silicon precursor is added to the gas mixture in a range comprised, in volume, between 10% and 100% of the monosilane.
